# EUROPEAN PATENT APPLICATION

(11) **EP 1 584 932 A1**
(43) Date of publication of application: **12.10.2005**
(21) Application number: 05075799.6
(22) Date of filing: 07.04.2005
(51) Int. Cl.: G01R 31/26

(54) **Method of testing semiconductor wafers with non-penetrating probes**

(30) Priority: 08.04.2004 US 560682 P; 05.04.2005 US 99148
(71) Applicant: Solid State Measurements, Inc., Pittsburgh, PA 15275 (US)
(72) Inventor: Mazur, Robert G., Sewickley, PA 15143 (US); Healy, James E., Carnegie, PA 15106 (US); Hillard, Robert J., Avalon, PA 15202 (US)
(74) Representative: van Westenbrugge, Andries

(57) **Abstract**

A sheet resistance test of a wafer (4) or sample can be performed by causing a plurality of spaced contacts (10,12), each of which either does not form oxides thereon or which forms conductive oxides thereon, to touch a surface (18) of the wafer without penetrating or damaging the surface. An electrical stimulus is then applied to the wafer via one or more of the contacts and the electrical response of the semiconducting material to the electrical stimulus is detected via one or more of the contacts. At least one electrical property of the wafer can be determined from the measured response and the applied electrical stimulus.

## Description

### CROSS REFERENCE TO RELATED APPLICATIONS

This application claims priority from United States Provisional Patent Application No. 60/560,682, filed April 8, 2004, which is incorporated herein by reference.

### BACKGROUND OF THE INVENTION

### Field of the Invention

The present invention relates to determining electrical characteristics of a semiconductor wafer or sample, a semiconductor-on-insulator wafer or sample or a film deposited on either one and, more particularly, for determining such characteristics in a non-destructive manner.

### Description of Related Art

Heretofore, sheet resistance testing of semiconducting material of a semiconductor wafer or sample, or of a semiconductor-on-insulator (SOI) wafer or sample has involved the use of a plurality of contacts or probes having tips, each of which is formed from a relatively hard and inelastic conductive material, such as an alloy or tungsten and one of several other metals. These probes are typically mounted to a mechanical holding device having a spring to provide compliance and contact pressure for each tip and precision sliding bearings to allow each tip to retract in compliance to the sample surface. The sample being tested typically includes an overlying dielectric layer or film, either placed there intentionally or occurring naturally in the case of silicon. During testing, two or more of these probes (depending on the test being performed) are caused to penetrate the dielectric film to contact the surface of the semiconducting material. This penetration results from the hardness of the probe tips and from the pressure applied. While this penetration of the dielectric is necessary to make contact to the underlying layer or material, it has the undesirable consequence of also penetrating into the semiconducting material itself.

Each area of the semiconducting material of a wafer or sample where a sheet resistance test is to be performed includes dopant atoms that have been introduced into the semiconducting material in a manner known in the art to alter its electrical properties. As the size of integrated circuits that are formed on wafers continues to decrease as a result of improved processing techniques, the depth to which dopant atoms are introduced into the semiconducting material of each wafer has decreased, whereupon today such dopant atoms are often introduced into a volume of the semiconducting material adjacent the surface thereof to a depth of less than about 50 nm.

It is well known in the art that the conductivity of the volume where the dopant atoms are introduced is often different from that of the underlying semiconducting material, e.g., an N-type volume over a P-type substrate, or vice versa. Hence, when the probes utilized to perform a sheet resistance test of a wafer or sample penetrate the surface of the semiconducting material, often to a depth of greater than several tens of nanometers (nm), the tip of one or more probes is often positioned in the semiconducting material at a level below the level of a space-charge region (or junction) between the volume and the underlying semiconducting material. It has been observed that when one or more probes penetrate this junction, one or more properties of the underlying semiconducting material are incorporated into the measurement whereupon the measurement accuracy is compromised. In addition, since a sheet resistance test of the semiconducting material of a wafer or a film formed thereon is typically conducted at numerous points on the wafer, the damage resulting from such tests renders the wafer unsuitable for use as a production wafer to produce integrated circuits.

Accordingly, what is needed to overcome the above problems and others is a method for performing a sheet resistance test of the semiconducting material of a wafer or a film formed thereon that does not require penetration of the semiconducting material or of the film in order to perform such test and which is desirably non-destructive.

### SUMMARY OF THE INVENTION

The invention is a method of testing a semiconductor sample. The method includes (a) providing a plurality of spaced contacts, wherein each contact is formed from an elastically deformable and electrically conductive material that either does not form oxides thereon or which forms conductive oxides thereon; (b) causing the contacts and a surface of the semiconductor sample to touch whereupon the contacts deform within their elastic limits but do not penetrate or damage the surface of the semiconductor sample; (c) causing a current to flow in the semiconductor sample via a subset of the contacts; (d) measuring a voltage induced in the semiconductor sample in response to the current flowing therein; and (e) determining at least one electrical characteristic of the semiconductor sample as a function of the value of the current flowing therein and the measured voltage.

The subset of contacts can include all or less than all of the plurality of contacts.

In the method, step (a) can include providing two contacts; step (c) can include causing the current to flow in the semiconductor sample via the two contacts; step (d) can include measuring the voltage induced in the semiconductor sample via the two contacts; and step (e) can include determining at least one of a resistivity of the semiconductor sample, a sheet resistance of the semiconductor sample, and a density of dopant atoms that have been introduced into semiconducting material of the semiconductor sample to alter its electrical properties.

Alternatively, step (a) can include providing three contacts; step (c) can include causing the current to flow in the semiconductor sample via two of the contacts; step (d) can include measuring the voltage induced in the semiconductor sample via the remaining contact and one of the current-carrying contacts; and step (e) can include determining at least one of a resistivity of the semiconductor sample, a sheet resistance of the semiconductor sample, and a density of dopant atoms that have been introduced into semiconducting material of the semiconductor sample to alter its electrical properties.

Alternatively, step (a) can include providing four contacts; step (c) can include causing the current to flow in the semiconductor sample via two of the contacts; step (d) can include measuring the voltage induced in the semiconductor sample via the two other contacts; and step (e) can include determining at least one of a resistivity of the semiconductor sample, a sheet resistance of the semiconductor sample, and a density of dopant atoms that have been introduced into semiconducting material of the semiconductor sample to alter its electrical properties. The physical spacing and relative locations of the four contacts can be selected to define the region of the semiconductor sample where the at least one electrical characteristic of the semiconductor sample is determined.

The plurality of contacts can be spaced linearly.

The method can further include repeating steps (c) - (d) a plurality of times with a different positioning of the subset of contacts for each repetition of steps (c) - (d), wherein step (e) includes determining as a function of the current flowing in the semiconductor sample and the measured voltage for each repetition of steps (c) - (d) at least one of a resistivity of the semiconductor sample, a sheet resistance of the semiconductor sample, and a density of dopant atoms that have been introduced into semiconducting material of the semiconductor sample to alter its electrical properties.

If the semiconductor sample includes a dielectric coating overlaying semiconducting material, the contacts can touch a surface of the dielectric coating opposite the semiconducting material and the current can be a tunneling current which flows through the dielectric coating between the semiconducting material and each of the subset contacts. Desirably, the current is constrained whereupon no irreversible changes occur to the dielectric coating.

The dielectric coating can be an intentionally applied (or grown) coating and/or a coating that grows on the semiconductor material in response to exposure to ambient atmosphere.

The dielectric coating can be a layer of silicon dioxide having a thickness less than or equal to 3 nm.

The contacts can each be formed from one of platinum and iridium.

The semiconductor sample can include semiconducting material having dopant atoms that have been introduced thereinto via a surface thereof to alter its electrical properties. The dopant atoms can form a semiconductor junction, such as a P-N junction, below said surface.

The dopant atoms desirably reside in the semiconducting material adjacent said surface and the current in step (c) is constrained to the semiconducting material containing said dopant atoms. The semiconductor sample can include a dielectric coating overlaying the semiconducting material. The current flowing between the semiconducting material and each of the subset of contacts inn step (c) can be a tunneling current that is constrained whereupon no irreversible changes occur to the dielectric coating. The tunneling current can also be constrained to flow in a layer of the semiconducting material adjacent a surface thereof.

The current in step (c) can be either a DC current or a DC current having an AC current superimposed thereon. The AC current can have a maximum or peak value that does not significantly vary a resistivity of the semiconductor sample. The current in step (c) can be one of a plurality of DC currents wherein each of the plurality of DC currents has a value whereupon a resistivity determined for the semiconductor sample for each value of DC current is substantially similar.

The invention is also a method of testing a semiconductor layer on a supporting wafer sample that includes (a) providing a plurality of spaced probes, wherein each probe is formed of an elastically deformable and electrically conductive material that either does not form an oxide(s) or other insulator on its surface or which forms a conductive oxide(s) or other material thereon; (b) causing the probes and a surface of the semiconductor layer to touch whereupon tips of the probes deform within their elastic limits but do not penetrate or damage the surface of the semiconductor layer; (c) causing a current to flow in the semiconductor layer via a first subset of the contacts; (d) measuring a voltage induced in the semiconductor layer in response to the current flowing therein via a second subset of the contacts; and (e) determining at least one electrical characteristic of the semiconductor layer as a function of the value of the current flowing therein and the measured voltage.

The first and second subset of contacts can be same or different and each subset of contacts can include all or less than all of the plurality of contacts.

In the method, step (a) can include providing two contacts; step (c) can include causing the current to flow in the semiconductor layer via the two contacts; step (d) can include measuring the voltage induced in the semiconductor layer via the two contacts; and step (e) can include determining at least one of a resistivity of the semiconductor layer, a sheet resistance of the semiconductor layer, and a density of dopant atoms that have been introduced into semiconducting material of the semiconductor layer to alter its electrical properties.

Alternatively, step (a) can include providing three contacts; step (c) can include causing the current to flow in the semiconductor layer via two of the contacts; step (d) can include measuring the voltage induced in the semiconductor layer via the remaining contact and one of the current-carrying contacts; and step (e) can include determining at least one of a resistivity of the semiconductor layer, a sheet resistance of the semiconductor layer, and a density of dopant atoms that have been introduced into semiconducting material of the semiconductor layer to alter its electrical properties.

Alternatively, step (a) can include providing four contacts; step (c) can include causing the current to flow in the semiconductor layer via two of the contacts; step (d) can include measuring the voltage induced in the semiconductor layer via the two other contacts; and step (e) can include determining at least one of a resistivity of the semiconductor layer, a sheet resistance of the semiconductor layer, and a density of dopant atoms that have been introduced into semiconducting material of the semiconductor layer to alter its electrical properties.

The physical spacing and relative locations of the four contacts can be selected to defme the region of the semiconductor layer where the at least one electrical characteristic of the semiconductor layer is determined.

The plurality of contacts can be spaced linearly.

Steps (c) - (d) can be repeated a plurality of times with a different spacing or positioning between the subset of contacts for each repetition of steps (c) - (d), wherein step (e) includes determining as a function of the current flowing in the semiconductor layer and the measured voltage for each repetition of steps (c) - (d) at least one of a resistivity of the semiconductor layer, a sheet resistance of the semiconductor layer, and a density of dopant atoms that have been introduced into semiconducting material of the semiconductor layer to alter its electrical properties.

The semiconductor layer can include a dielectric coating overlaying semiconducting material. In step (b) the contacts can touch a surface of the dielectric coating opposite the semiconducting material and in step (c) the current can be a tunneling (or leakage) current which flows through the dielectric coating between the semiconducting material and each of the subset contacts.

The current can be constrained whereupon no irreversible changes occur to the dielectric coating. The dielectric coating can either be an intentionally applied coating or a native oxide coating that grows on the semiconductor material in response to exposure to an ambient atmosphere. The dielectric coating can be a layer of silicon dioxide having a thickness desirably less than or equal to 30 angstroms.

The contacts can each be formed from one of platinum and iridium.

The semiconductor layer can be comprised of semiconducting material and the semiconducting material can include dopant atoms that have been introduced thereinto via a surface thereof to alter its electrical properties. The dopant atoms can form a P-N junction below said surface.

The dopant atoms can reside in the semiconducting material adjacent said surface and the current in step (c) can be constrained to the semiconducting material containing said dopant atoms.

The semiconductor layer can include a dielectric coating overlaying the semiconducting material.

The current flowing between the semiconducting material and each of the subset of contacts in step (c) can be a tunneling (or leakage) current that is constrained whereupon no irreversible changes occur to the dielectric coating. The current can also be constrained to flow in a layer of the semiconducting material adjacent a surface thereof.

The current in step (c) can either be a DC current or a DC current having an AC current superimposed thereon. The AC current can have a maximum or peak value that does not significantly vary a resistivity of the semiconductor layer. The DC current in step (c) can be one of a plurality of DC currents. Each of the plurality of DC currents has a value whereupon a resistivity determined for the semiconductor layer for each value of DC current is substantially similar.

Lastly, the invention is a method of testing a conductive film overlaying a semiconductor wafer or sample comprising (a) providing a plurality of spaced contacts, wherein each contact is formed from an elastically deformable and electrically conductive material that either does not form an oxide(s) thereon or which forms a conductive oxide(s) thereon; (b) causing the contacts and a surface of the conductive film to touch whereupon the contacts deform within their elastic limits but do not penetrate or damage the surface of the conductive film; (c) causing a current to flow in the conductive film via a subset of the contacts; (d) measuring a voltage induced in the conductive film in response to the current flowing therein; and (e) determining at least one electrical characteristic of the conductive film as a function of the value of the current flowing therein and the measured voltage.

### BRIEF DESCRIPTION OF THE DRAWINGS

Fig. 1A is a combined block diagram and cross-sectional side view of a semiconductor wafer received on a vacuum chuck of a first embodiment apparatus for measuring electrical characteristics of the semiconductor wafer;

Fig. 1B is an enlarged view of a distal end of one of the contacts shown in Fig. 1A;

Fig. 2 is the apparatus and the semiconductor wafer shown in Fig. 1A wherein the semiconductor wafer includes a layer, either a dielectric layer or a conductive layer, overlaying the semiconductor substrate of the semiconductor wafer;

Fig. 3 is a combined block diagram and cross-sectional side view of a semiconductor wafer received on the vacuum chuck of a second embodiment apparatus for measuring electrical properties of the semiconductor wafer;

Fig. 4 is the apparatus and semiconductor wafer shown in Fig. 3 wherein the semiconductor wafer includes a layer, either a dielectric layer or a conductive layer, overlaying the semiconductor substrate of the semiconductor wafer;

Fig. 5 is a combined block diagram and cross-sectional side view of a semiconductor wafer received on the vacuum chuck of a third embodiment apparatus for measuring electrical properties of the semiconductor wafer;

Fig. 6 is the apparatus and the semiconductor wafer shown in Fig. 5 wherein the semiconductor wafer includes a layer, either a dielectric layer or a conductive layer, overlaying the semiconductor substrate of the semiconductor wafer;

Fig. 7A is a combined block diagram and cross-sectional side view of a semiconductor wafer received on the vacuum chuck of a fourth embodiment apparatus for measuring electrical properties of the semiconductor wafer;

Fig. 7B is a view taken along lines VII B-VII B in Fig. 7A;

Fig. 8 is the apparatus and the semiconductor wafer shown in Fig. 7A wherein the semiconductor wafer includes a layer, either a dielectric layer or a conductive layer, overlaying the semiconductor substrate of the semiconductor wafer; and

Fig. 9 is an isolated view of a semiconductor-on-insulator wafer received on the vacuum chuck of the apparatus shown in any one of Figs. 1A and 2-8.

### DETAILED DESCRIPTION OF THE INVENTION

The present invention will be described with reference to the accompanying figures where like reference numbers correspond to like elements.

### Two Probe Sheet Resistance Test Of A Bare Wafer or Sample:

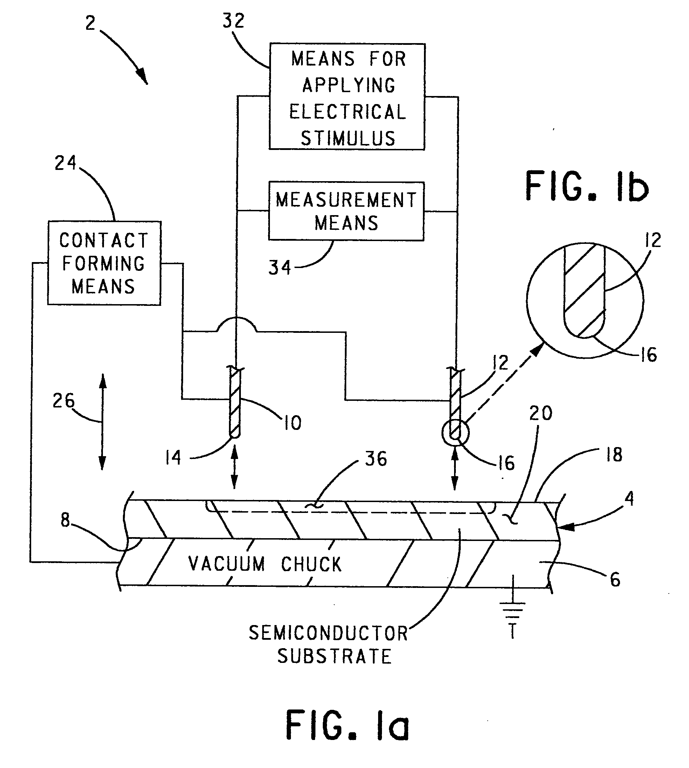

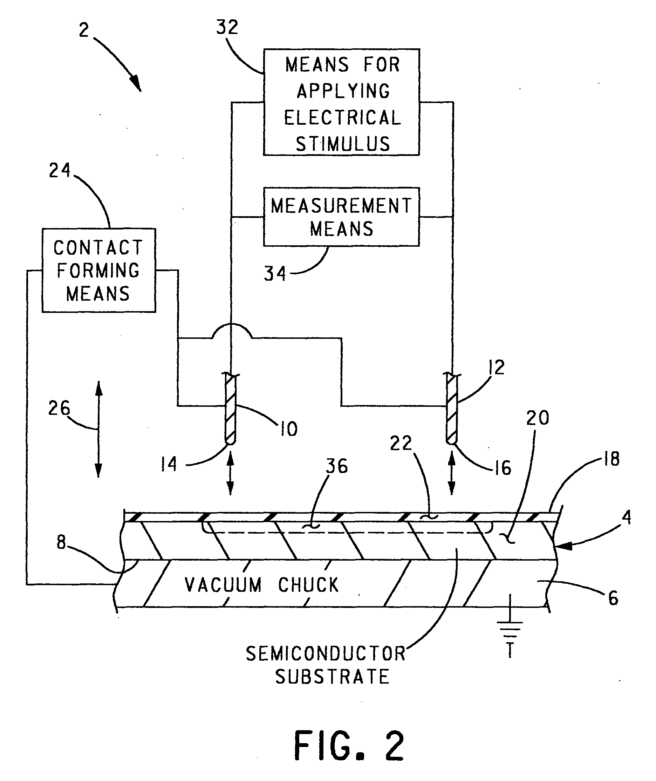

With reference to Fig. 1A, an apparatus 2 for performing a sheet resistance test of a semiconductor wafer or sample 4 includes a vacuum chuck 6 for supporting a backside 8 of wafer 4 by means of a vacuum (not shown). Vacuum chuck 6 can be electrically conductive or electrically non-conductive, as desired, as determined by the type of wafer being tested. Accordingly, the electrical conductivity or lack thereof of vacuum chuck 6 is not to be construed as limiting the invention. Apparatus 2 also includes a pair of contacts or probes 10 and 12 defining electrically conductive portions 14 and 16, respectively, for making contact with a surface or topside 18 of wafer 4. In Fig. 1A, topside 18 is illustrated as being the exposed surface of a semiconductor substrate 20, formed from a suitable semiconducting material, that defines semiconductor wafer 4. However, as shown in Fig. 2, wafer 4 can include a layer or film 22 formed from a dielectric, e.g., SiO₂ whereupon topside 18 of wafer 4 is the exposed surface of layer 22.

At least conductive portions 14 and 16 of contacts 10 and 12, respectively, are formed from an elastically deformable material, e.g., a smooth, highly polished metal such as platinum or iridium, that either does not form oxides on the surface thereof or which forms conductive oxides on the surface thereof. Contacts 10 and 12 can have the form of elongated probes with conductive portions 14 and 16, respectively, defining tips of the probes, each of which has an approximately hemispherical shape, shown best in Fig. 1B. The description of contacts 10 and/or 12 as having the form of probes with tips having approximately hemispherical shapes, however, is not to be construed as limiting the invention.

Apparatus 2 includes a contact placement means 24, of a type well known in the art, for controlling the vertical movement of chuck 6 and/or contacts 10 and 12 in the directions shown by arrow 26 to move wafer 4 and contacts 10 and 12 toward each other until conductive portions 14 and 16 press into contact with topside 18 without damaging, e.g., scrubbing, wafer 4. A suitable contact placement means 24 for moving contacts 10 and/or 12 into contact with topside 18 is the kinematic probe arm disclosed in U.S. Pat. No. 5,023,561 to Hillard which issued on Jun. 11, 1991 and which is incorporated herein by reference. When pressed into contact with topside 18, conductive portions 14 and 16 elastically deform within their elastic limits but do not penetrate topside 18 or damage, e.g., scrub, wafer 4.

Apparatus 2 also includes a means for applying electrical stimulus 32 and a measurement means 34 connected to contacts 10 and 12. At a suitable time after conductive portions 14 and 16 are in contact with topside 18, means for applying electrical stimulus 32 applies a suitable electrical stimulus to semiconductor substrate 20, and measurement means 34 measures the response of semiconductor substrate 20 to the electrical stimulus. When performing a sheet resistance test of semiconductor substrate 20, the suitable electrical stimulus causes a DC current to flow in volume 36 between contacts 10 and 12. If desired, the suitable electrical stimulus may also cause an AC current to be superimposed on the DC current.

As is known in the art, a sheet resistance test of semiconductor substrate 20 is conducted on a volume 36 below topside 18. Volume 36 can either be the intrinsic semiconductor material forming semiconductor substrate 20 or can be the intrinsic semiconductor material having suitable dopant atoms introduced thereinto to alter its electrical property, e.g., to form a suitable space-charge region or junction such as, without limitation, a P-N junction. In Figs. 1A and 2-9, volume 36 is illustrated as an isolated portion of semiconductor substrate 20 below topside 18. However, this is not to be construed as limiting the invention since volume 36 can constitute any desired percentage of semiconductor substrate 20 below topside 18.

When the current is flowing in volume 36, measurement means 34 measures a response of wafer 4 to the current in the form of a voltage induced in volume 36 between contacts 10 and 12. This process may be repeated a plurality of times for different currents and voltages. Each current and its corresponding voltage can then be plotted as a point on a voltage versus current graph. Thereafter, a slope of a line joining all of the points or the slope of a best fit line to the points can be measured to determine the sheet resistance of volume 36. Based on this sheet resistance, the resistivity of volume 36 can be determined in a manner known in the art.

A doping concentration of (or a density of dopant atoms in) volume 36 can be determined from the resistivity determined for volume 36 utilizing the procedure set forth in ASTM standard F723-99, or in any other suitable manner.

Heretofore, when performing a prior art sheet resistance test, contacts in the form of probes, each formed from a hard and inelastic material, penetrated into semiconductor substrate 20 to a depth of several tens of nanometers. While this type of sheet resistance test can be conducted on test wafers, it is obviously not suitable for product wafers. Moreover, with the continued miniaturization of devices associated with integrated circuits formed on today's wafers, dopant atoms are introduced into volume 36 of semiconductor substrate 20 to a depth of less than about 50 nm from topside 18, with a majority of the dopant atoms residing adjacent topside 18. It has been observed, however, that performing a prior art sheet resistance test on such wafers utilizing contacts that penetrate into volume 36 produces substantial errors in the measurement of sheet resistance because the penetrating or distal end of one or more of the contacts is typically positioned below the junction between volume 36 and the underlying semiconducting material.

To overcome these problems, the present invention utilizes elastically deformable and conductive contacts that either do not form oxides or form conductive oxides. Use of these contacts along with the suitable contact placement means 24 described above avoids penetrating and/or damaging topside 18 of semiconductor substrate 20 when performing a sheet resistance test. Hence, the use of these contacts enables sheet resistance testing of product wafers.

### Two Probe Sheet Resistance Test Of A Wafer or Sample Having An Overlaying Dielectric Layer:

With reference to Fig. 2, wafers 4 currently being manufactured typically include a layer 22 in the form of a dielectric, e.g., a native dielectric such as SiO₂ and/or an intentionally applied dielectric, having a thickness of ≤ about 3 nm. Because layer 22 in the form of a dielectric is relatively thin, contacts 10 and 12 can also be utilized for performing a sheet resistance test of wafer 4 including layer 22. To this end, contact placement means 24 causes conductive portions 14 and 16 to press into contact with topside 18 of layer 22 such that conductive portions 14 and 16 elastically deform within their elastic limits but do not penetrate topside 18 or damage wafer 4. Thereafter, means for applying electrical stimulus 32 applies to contacts 10 and 12 a suitable electrical stimulus that causes a tunneling current to flow through layer 22 while avoiding the application of sufficient energy that would cause irreversible changes to layer 22.

In response to the tunneling current flowing through layer 22, a corresponding current flows in each contact 10 and 12 and in volume 36. During the time this current is flowing in volume 36, measurement means 34 measures the response of volume 36 to the current in the form of a voltage between contacts 10 and 12. This process may be repeated a plurality of times for different currents and voltages. Each current and its corresponding voltage can then be plotted as a point on a voltage versus current graph. Thereafter, a slope of a line joining all of the points or the slope of a best fit line to the points can be measured to determine the sheet resistance of volume 36. Based on this sheet resistance, the resistivity of volume 36 may be determined even when dielectric layer 22 is present.

Because conductive portions 14 and 16 either form no oxides or form conductive oxides, when conductive portions 14 and 16 press into contact with layer 22, the application of the electrical stimulus and the measured response to the electrical stimulus is unaffected thereby.

An example of a suitable electrical stimulus that can be applied between contacts 10 and 12 when layer 22 in the form of a dielectric has a thickness of approximately 1.4 nm is about 45 Volts.

Because conductive portions 14 and 16 of contacts 10 and 12, respectively, do not penetrate topside 18 or damage wafer 4 during testing, sheet resistance testing of product wafers can be performed. This is in contrast to prior art methods of performing sheet resistance testing of test wafers having layer 22 in the form of a dielectric overlaying semiconductor substrate 20 wherein, hard inelastic probes were required to penetrate layer 22 to make contact with semiconductor substrate 20.

### Two Probe Sheet Resistance Test Of A Wafer or Sample Having An Overlaying Conductive Film:

When layer 22 is a conductor, pressing conductive portions 14 and 16 into contact with layer 22 enables a sheet resistance test of layer 22 to be performed in the manner described above in connection with the two probe sheet resistance test of a bare wafer.

In the foregoing descriptions of two probe sheet resistance tests, the distance between contacts 10 and 12 was not varied. If desired, however, the spacing between contacts 10 and 12 can be varied a plurality at times and the current flowing through volume 36 and the voltage induced therein as a result of said current can be measured for each spacing of contacts 10 and 12. Each current and its corresponding voltage can then be plotted as a point on a voltage versus current graph. Thereafter, a slope of a line joining all of the points or the slope of a best fit line to the points can be measured to determine the sheet resistance of volume 36. Based on this sheet resistance, the resistivity of volume 36 can be determined in a manner known in the art.

### Three Probe Sheet Resistance Test Of A Bare Wafer:

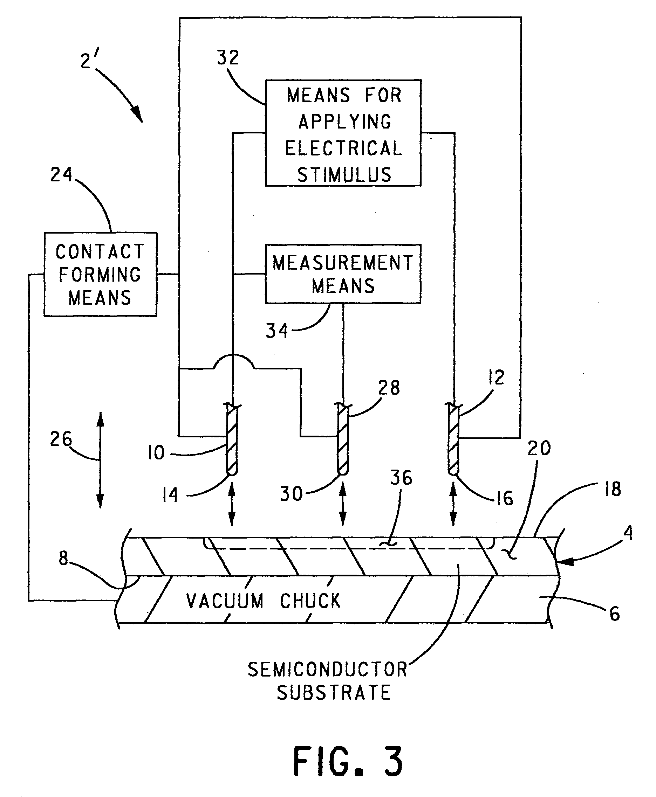

With reference to Fig. 3 and with continuing reference to Figs. 1A-2, while the sheet resistance tests described above utilized two contacts, it is envisioned that an apparatus 2' having three contacts 10, 12 and 28 can be utilized for testing where one contact, e.g., contact 28, serves as the common contact for both the means for applying electrical stimulus 32 and the measurement means 34 whereupon this common contact is the only one contributing to the measurement. Apparatus 2' is similar to apparatus 2 shown in Fig. 1A, except that apparatus 2' further includes contact 28 which is similar to contacts 10 and 12. Contact 28 includes conductive portion 30 formed from the same material and having the same shape as conductive portions 14 and 16 of contacts 10 and 12, respectively. Contacts 10, 12 and 28 desirably have their conductive portions 14, 16 and 30 arranged linearly. However, this is not to be construed as limiting the invention.

When testing volume 36 of wafer 4 shown in Fig. 3, contact placement means 24 causes conductive portions 14, 16 and 30 to press into contact with topside 18 of semiconductor substrate 20 above volume 36. Means for applying electrical stimulus 32 then applies a suitable electrical stimulus to contacts 10 and 12 whereupon a current flows in volume 36 via contacts 10 and 12. While this current is flowing, measurement means 34 measures a voltage induced in volume 36 between contacts 10 and 28 (or contacts 12 and 28) in response to this current. Utilizing the value of the current flowing in volume 36 along with the value of the measured voltage, an electrical characteristic of volume 36 can be determined.

### Three Probe Sheet Resistance Test Of A Wafer or Sample Having An Overlaying Dielectric Layer:

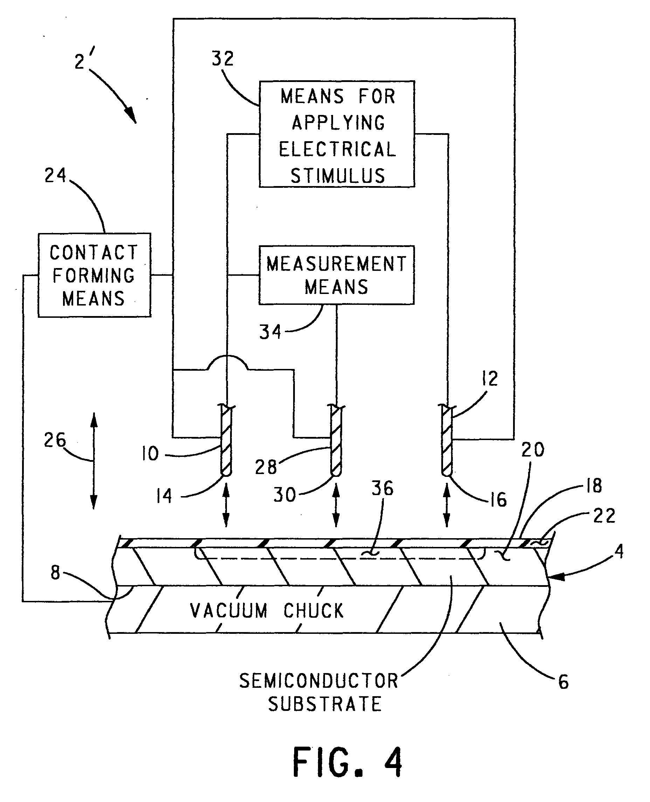

With reference to Fig. 4, and with continuing reference to Figs. 1A-3, the sheet resistance test utilizing contacts 10, 12 and 28 can also be performed on wafer 4 including layer 22. When layer 22 is a dielectric, it desirably has a thickness, e.g., ≤ 3.0 nm, that will permit a tunneling current to flow across layer 22 in response to the application of a suitable electrical stimulus to contacts 10 and 12. The value of the suitable electrical stimulus is selected to cause the tunneling current to flow across layer 22 while avoiding electrical breakdown thereof that would irreversibly change layer 22.

When apparatus 2' is used for testing wafer 4 including layer 22 in the form of a dielectric overlaying semiconductor substrate 20, contact placement means 24 causes portions 14, 16 and 30 to press into contact with topside 18 of layer 22 above volume 36. Thereafter, means for applying electrical stimulus applies a suitable electrical stimulus to contacts 10 and 12 that causes a tunneling current to flow across layer 22 while avoiding electrical breakdown thereof that would cause irreversible changes to layer 22.

In response to the tunneling current flowing across layer 22, a corresponding current flows in each contact 10 and 12 and in volume 36. When this current is flowing in volume 36, measurement means 34 measures a voltage induced in volume 36 between contacts 10 and 28 (or contacts 12 and 28) by this current. The ability to measure the voltage between contacts 10 and 28 (or contacts 12 and 28) results from a tunneling current flowing from volume 36 to contact 28 via layer 22. Utilizing the value of the current flowing in volume 36 between contacts 10 and 12 along with the voltage measured between contacts 10 and 28 (or contacts 12 and 28), a sheet resistance of volume 36 and, hence, the resistivity of volume 36 can be determined.

### Three Probe Sheet Resistance Test of A Wafer or Sample An Overlaying Conductive Film:

When layer 22 is a conductor, pressing conductive portions 14, 16 and 30 of apparatus 2' into contact with layer 22 enables a sheet resistance test of layer 22 to be performed in the manner described above in connection with the three probe sheet resistance test of a bare wafer.

### Four Probe Sheet Resistance Test Of A Bare Wafer:

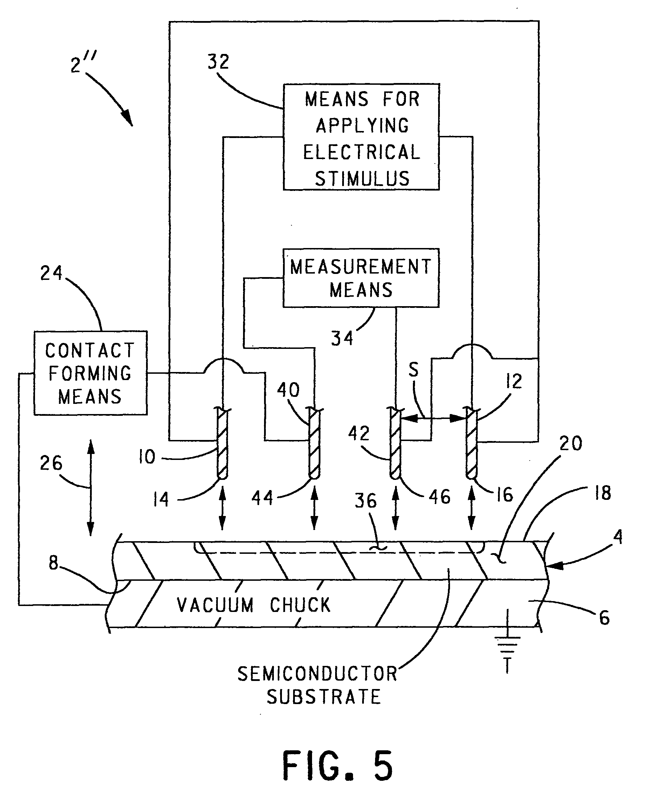

With reference to Fig. 5, an apparatus 2" for performing a sheet resistance test of semiconductor wafer 4 will now be described. Apparatus 2" is similar to apparatus 2 shown in Fig. 1A except that apparatus 2" further includes contacts 40 and 42. Contacts 40 and 42 include conductive portions 44 and 46, respectively, formed from the same material and having the same shape as conductive portions 14 and 16 of contacts 10 and 12, respectively. Contacts 10, 12, 40 and 42 desirably have their conductive portions 14, 16, 44 and 46, respectively, arranged linearly at a spacing S between .5 and 4.5 millimeters between adjacent conductive portions. However, this linear arrangement and spacing are not to be construed as limiting the invention.

When performing a sheet resistance test of volume 36 of semiconductor substrate 20, contact placement means 24 causes conductive portions 14, 16, 44 and 46 to press into contact with topside 18 of semiconductor substrate 20 above volume 36. Means for applying electrical stimulus 32 then applies a suitable electric stimulus to a first pair of contacts, e.g., contacts 10 and 12, contacts 12 and 40, or contacts 10 and 42, whereupon a current flows in volume 36 via said contacts. Measurement means 34 then measures a voltage induced in volume 36 via in response to the current flowing in volume 36 a second pair of the contacts, e.g., contacts 40 and 42, contacts 10 and 12, or contacts 12 and 40. When contacts 10 and 12, contacts 12 and 40, or contacts 10 and 42 are utilized for applying the electrical stimulus, contacts 40 and 42, contacts 10 and 42, or contacts 12 and 40, respectively, are utilized to measure the voltage induced in volume 36. Utilizing the value of the current flowing in volume 36 along with the value of the measured voltage, the sheet resistance and, hence, the resistivity of volume 36 can be determined in a manner well known in the art.

Because conductive portions 14, 16, 44 and 46 of contacts 10, 12, 40 and 42, respectively, do not penetrate topside 18 during testing, errors in the measurement of the sheet resistance of volume 36, having a majority of its dopant atoms adjacent topside 18 thereof, are avoided. Moreover, because conductive portions 14, 16, 44 and 46 do not penetrate topside 18 during testing, sheet resistance testing of product wafer can be performed.

### Four Probe Sheet Resistance Testing Of A Wafer or Sample Having An Overlaying Dielectric Layer:

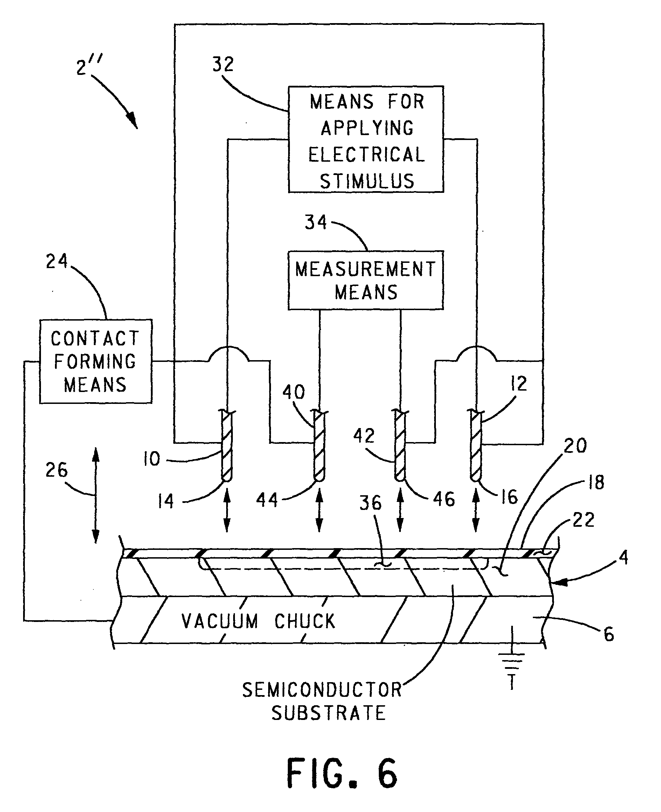

With reference to Fig. 6, apparatus 2" can also be utilized for determining the sheet resistance and, hence, resistivity of volume 36 of semiconductor wafer 4 when semiconductor wafer 4 includes layer 22 in the form of a dielectric overlaying semiconductor substrate 20. In this case, conductive portions 14, 16, 44 and 46 of contacts 10, 12, 40 and 42 are caused to press into contact with topside 18, which in this case is the exposed surface of layer 22 in the form of a dielectric, above volume 36. Desirably, layer 22 in the form of a dielectric has a thickness that will permit a tunneling current to flow therethrough in response to the application of a suitable electrical stimulus to a first pair of contacts. Thereafter, means for applying electrical stimulus 32 applies to the first pair of contacts, e.g., contacts 10 and 12, a suitable electrical stimulus that causes a tunneling current to flow across layer 22 while avoiding electrical breakdown thereof that would cause irreversible changes to layer 22.

In response to the tunneling current flowing across layer 22, a corresponding current flows in volume 36. During the time this current is flowing in volume 36, measurement means 34 measures the response of semiconductor substrate 20 to the current in the form of a voltage induced in volume 36 between a second pair of contacts, e.g., contacts 40 and 42. The ability to measure the voltage between the second pair of contacts results from a low level leakage current flowing between volume 36 and the second pair of contacts via layer 22. Utilizing the value of the current flowing in volume 36 between the first pair of contacts along with the voltage measured between the second pair of contacts, the sheet resistance and, hence, the resistivity of volume 36 can be determined.

### Four Probe Sheet Resistance Test Of A Wafer or Sample An Overlaying Conductive Layer:

When layer 22 is a conductor, pressing portions 14, 16, 44 and 46 of apparatus 2" into contact with layer 22 enables a sheet resistance test of layer 22 to be performed in the manner described above in connection with the four probe sheet resistance test of a bare wafer.

Apparatus 2" can also be utilized for performing a sheet resistance test in the manner described above in connection with apparatus 2 simply by utilizing only one pair of contacts 10, 12, 40 and 42 connected to means for applying electrical stimulus 32 and measurement means 34 in the manner contacts 10 and 12 are shown connected in Figs. 1A and 2.

Another manner in which apparatus 2" can be utilized for performing a sheet resistance test includes connecting means for applying electrical stimulus 32 to cause a first current to flow in volume 36 via contacts 10 and 40 and connecting measurement means 34 to measure a first voltage induced in volume 36 by this first current via contacts 10 and 40. Then, means for applying electrical stimulus 32 is connected to cause a second current to flow in volume 36 via contacts 10 and 42 and measurement means 34 is connected to measure a second voltage induced in volume 36 by the second current via contacts 10 and 42. Lastly, means for applying electrical stimulus 32 is connected to cause a third current to flow in volume 36 via contacts 10 and 12 and measurement means 34 is connected to measure a third voltage induced in volume 36 by this third current via contacts 10 and 12. For purpose of simplicity, the foregoing connections are not shown in Figs. 5 and/or 6.

Each thus measured current and its corresponding voltage can be plotted as a point on a graph of voltage versus current. A sheet resistance of volume 36 can then be determined from a slope of a line that either connects the points or the slope of a line that is a best fit to the points. Based upon this sheet resistance, a resistivity of volume 36 can be determined in a manner known in the art.

### Four Point Delta Probe Sheet Resistance Testing Of A Bare Wafer:

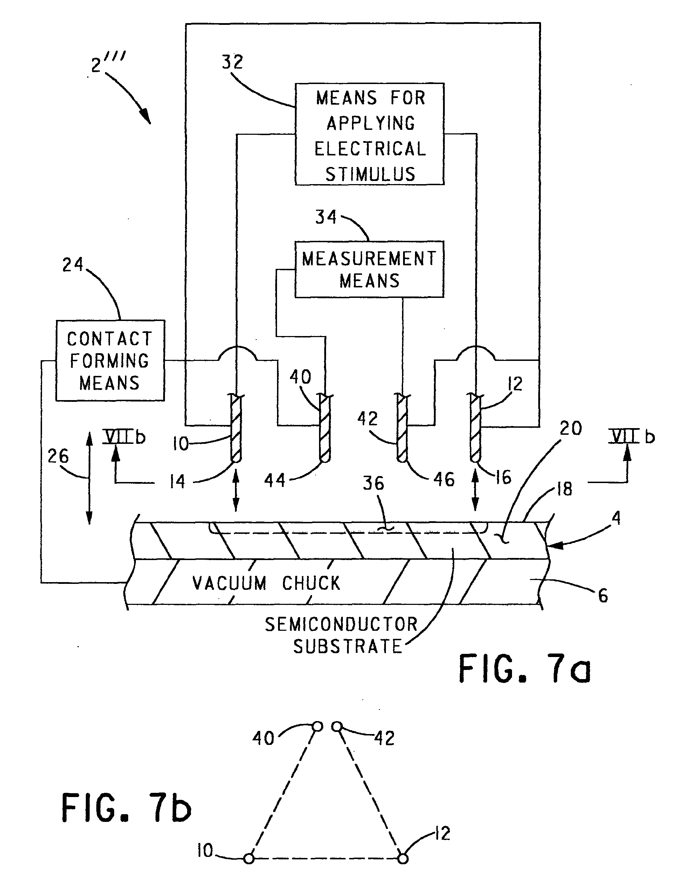

With reference to Figs. 7A and 7B, an apparatus 2'" for performing a sheet resistance test of semiconductor wafer 4 will now be described. Apparatus 2'" is similar to apparatus 2" shown in Fig. 5 except that contacts 10, 12, 40 and 42 are arranged in the delta-type pattern shown best in Fig. 7B. For testing the sheet resistance of volume 36 of semiconductor substrate 20, contact placement means 24 causes conductive portions 14, 16, 44 and 46 of contacts 10, 12, 40 and 42, respectively, to press into contact with topside 18 of semiconductor substrate 20 above volume 36. Means for applying electrical stimulus 32 then applies a suitable electrical stimulus to contacts 10 and 12 whereupon a current flows in volume 36 via said contacts. While this current is flowing, measurement means 34 measures a voltage induced in volume 36 via contacts 40 and 42 in response to this current. Utilizing the value of the current flowing in volume 36 along with the value of the measured voltage, the sheet resistance and, hence, the resistivity of volume 36 can be determined in a manner known in the art.

Because conductive portions 14, 16, 44 and 46 of contacts 10, 12, 40 and 42, respectively, do not penetrate topside 18 during testing, errors in the measurement of sheet resistance and, hence, resistivity of volume 36, having a majority of its dopant atoms adjacent topside 18 thereof, are avoided. Moreover, because conductive portions 14, 16, 44 and 46 do not penetrate topside 18 during testing, sheet resistance testing of product wafer can be performed.

### Four Point Delta Probe Sheet Resistance Test Of A Wafer or Sample Having An Overlaying Dielectric Layer:

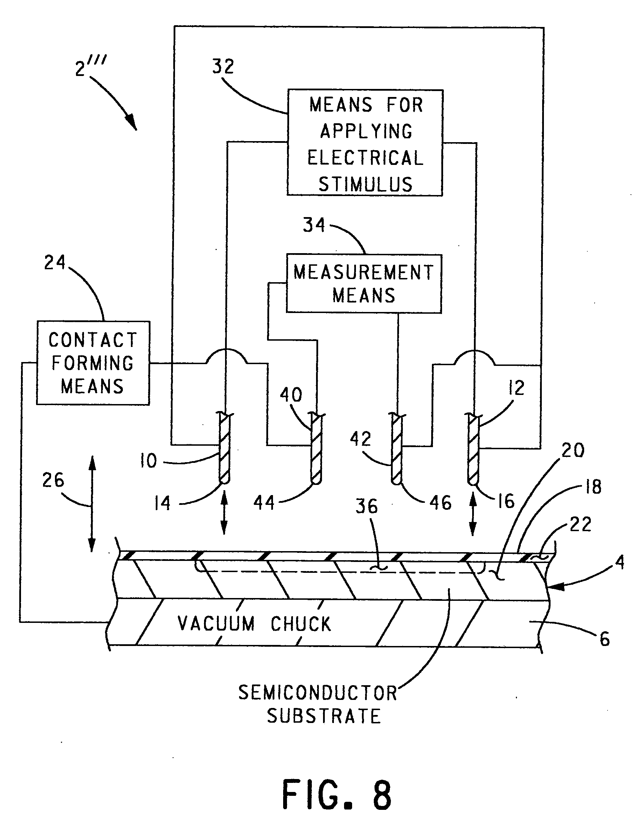

With reference to Fig. 8, apparatus 2'" can also be utilized for determining the sheet resistance, and, hence, resistivity of volume 36 of semiconductor wafer 4 when semiconductor wafer 4 includes layer 22 in the form of a dielectric overlaying semiconductor substrate 20. In this case, conductive portions 14, 16, 44 and 46 of contacts 10, 12, 40 and 42, respectively, press into contact with topside 18, which in this case is the exposed surface of layer 22 in the form of a dielectric, above volume 36. Thereafter, means for applying electrical stimulus 32 applies to contacts 10 and 12 a suitable electrical stimulus that causes a tunneling current to flow across layer 22 while avoiding electrical breakdown thereof that would cause irreversible changes to layer 22.

In response to the tunneling current flowing across layer 22, a corresponding current flows in each contact 10 and 12 and in volume 36. During the time this current is flowing in volume 36, measurement means measures the response of semiconductor substrate 20 to the current in the form of a voltage induced in volume 36 between contacts 40 and 42. The ability to measure the voltage between contacts 40 and 42 results from a leakage current flowing between volume 36 and contacts 40 and 42 via layer 22. Utilizing the value of the current flowing in volume 36 between contacts 10 and 12 along with the voltage measured between contacts 40 and 42, a sheet resistance of volume 36 and, hence, the resistivity of volume 36 can be determined.

### Four Point Delta Probe Sheet Resistance Testing Of A Wafer Or Sample Having An Overlaying Conductive Layer:

When layer 22 is a conductor, pressing portions 14, 16, 44 and 46 of apparatus 2" into contact with topside 18 enables a sheet resistance test of layer 22 to be performed in a manner described above in connection with the four point delta probe sheet resistance test of a bare wafer.

### Sheet Resistance Test Of A Semiconductor-On-Insulator Wafer:

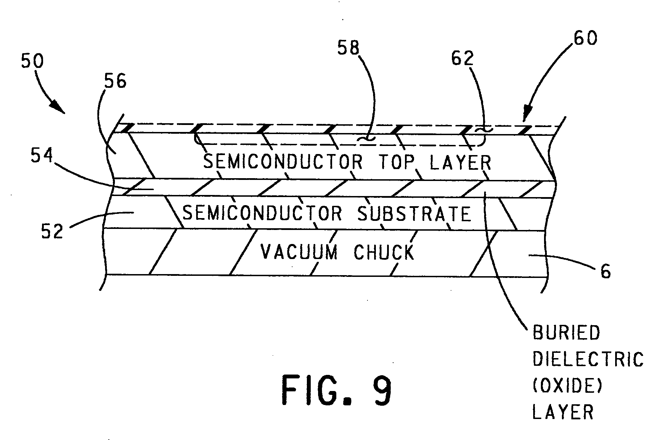

In the foregoing description, wafer 4 is described as being comprised of semiconductor substrate 20 formed from semiconducting material. If desired, however, the contacts described above can be utilized to test a semiconductor-on-insulator (SOI) wafer 50 of the type shown in Fig. 9 received on vacuum chuck 6. SOI wafer 50 may include an optional semiconductor substrate 52, a dielectric (oxide) layer 54 and a semiconductor top layer 56 overlaying oxide layer 54. Semiconductor top layer 56 can include a volume 58, like volume 36 of semiconductor substrate 20, where dopant atoms have been introduced into semiconductor top layer 56 to alter its electrical properties. A topside 60 of SOI wafer 50 can be the exposed surface of semiconductor top layer 56 or the exposed surface of a layer 62 (shown in phantom) in the form of a dielectric or a conductor overlaying semiconductor top layer 56.

Apparatus 2 can be utilized for performing a sheet resistance test of volume 58 of semiconductor top layer 56, with or without layer 62 in the form of a dielectric, in the same manner described above for testing volume 36 of semiconductor substrate 20, with or without layer 22 in the form of a dielectric. In addition, apparatus 2 can be utilized for performing a sheet resistance test of layer 62 in the form of a conductor in the same manner described above for testing layer 22 in the form of a conductor. Moreover, apparatus 2', 2" or 2'" can be utilized for performing a sheet resistance test of volume 58 of semiconductor top layer 56, with or without layer 62 in the form of a dielectric, in the same manner described above for testing volume 36 of semiconductor substrate 20, with or without layer 22 in the form of a dielectric. Lastly, apparatus 2', 2" or 2'" can be utilized for performing a sheet resistance test of layer 62 in the form of a conductor in the same manner described above for testing layer 22 in the form of a conductor. Accordingly, detailed descriptions of the tests described above in connection with Figs. 1A and 2-8, but as applied to SOI wafer 50, will not be repeated herein to avoid unnecessary redundancy.

As can be seen, the above-described elastically deformable, conductive contacts, desirably in the form of elongated probes, having, at least, conductive portions formed from a material that either does not form oxides or form conductive oxides can be utilized for determining the sheet resistance and, hence, resistivity of semiconducting material of a semiconductor wafer of an SOI wafer, where the semiconducting material of said wafer has been doped with dopant atoms to a depth of less than about 50 nm. The contacts can be utilized either directly in contact with the surface of the doped semiconducting material or in contact with the surface of an overlaying dielectric (oxide) layer having a thickness that permits a tunneling current to flow thereacross. The use of these contacts in combination with semiconducting material doped with dopant atoms to a depth of less than about 50 nm, enables a sheet resistance test of the semiconducting material to be conducted in a non-destructive manner that avoids measurement inaccuracies that would result from the use of prior art contacts that penetrate or damage the semiconducting material and/or overlaying dielectric layer during such tests.

In addition, because the conductive portions of the above-described contacts either do not form oxides or form conductive oxides, the contacts can be utilized for performing a sheet resistance test of a layer of conductive material overlaying doped or un-doped semiconducting material without having to penetrate or damage the surface of the conductive layer.

The invention has been described with reference to the preferred embodiments. Obvious modifications and alterations will occur to others upon reading and understanding the preceding detailed description. For example, if the DC current has an AC current superimposed thereon, and the AC current has a maximum or peak value that does not significantly vary the resistivity of volume 36. If desired, a plurality of different values of DC current can be caused to flow in volume 36 and the resistivity for each value of DC current can be determined therefrom and the voltage dropped induced in volume 36 in response to the flow of the current. In this case, the value of each DC current is selected whereupon a resistivity determined for the semiconductor sample for each value of DC current is substantially similar. It is intended that the invention be construed as including all such modifications and alterations insofar as they come within the scope of the appended claims or the equivalents thereof.

## Claims

1. A method of testing a semiconductor sample comprising:
(a) providing a plurality of spaced contacts, wherein each contact is formed from an elastically deformable and electrically conductive material that either does not form an oxide(s) thereon or which forms a conductive oxide(s) thereon;
(b) causing the contacts and a surface of the semiconductor sample to touch whereupon the contacts deform within their elastic limits but do not penetrate or damage the surface of the semiconductor sample;
(c) causing a current to flow in the semiconductor sample via a subset of the contacts;
(d) measuring a voltage induced in the semiconductor sample in response to the current flowing therein; and
(e) determining at least one electrical characteristic of the semiconductor sample as a function of the value of the current flowing therein and the measured voltage.

2. The method of claim 1, wherein the subset of contacts includes all or less than all of the plurality of contacts.

3. The method of claim 1, wherein:
step (a) includes providing two contacts;
step (c) includes causing the current to flow in the semiconductor sample via the two contacts;
step (d) includes measuring the voltage induced in the semiconductor sample via the two contacts; and
step (e) includes determining at least one of a resistivity of the semiconductor sample, a sheet resistance of the semiconductor sample, and a density of dopant atoms that have been introduced into semiconducting material of the semiconductor sample to alter its electrical properties.

4. The method of claim 1, wherein:
step (a) includes providing three contacts;
step (c) includes causing the current to flow in the semiconductor sample via two of the contacts;
step (d) includes measuring the voltage induced in the semiconductor sample via the remaining contact and one of the current-carrying contacts; and
step (e) includes determining at least one of a resistivity of the semiconductor sample, a sheet resistance of the semiconductor sample, and a density of dopant atoms that have been introduced into the semiconducting material of the semiconductor sample to alter its electrical properties.

5. The method of claim 1, wherein:
step (a) includes providing four contacts;
step (c) includes causing the current to flow in the semiconductor sample via two of the contacts;
step (d) includes measuring the voltage induced in the semiconductor sample via the two other contacts; and
step (e) includes determining at least one of a resistivity of the semiconductor sample, a sheet resistance of the semiconductor sample, and a density of dopant atoms that have been introduced into semiconducting material of the semiconductor sample to alter its electrical properties.

6. The method of claim 5, wherein the physical spacing and relative locations of the four contacts is selected to define the region of the semiconductor sample where the at least one electrical characteristic of the semiconductor sample is determined.

7. The method of claim 1, wherein the plurality of contacts is spaced linearly.

8. The method of claim 1, further including repeating steps (c) - (d) a plurality of times with a different positioning of the subset of contacts for each repetition of steps (c) - (d), wherein step (e) includes determining as a function of the current flowing in the semiconductor sample and the measured voltage for each repetition of steps (c) - (d) at least one of a resistivity of the semiconductor sample, a sheet resistance of the semiconductor sample, and a density of dopant atoms that have been introduced into semiconducting material of the semiconductor sample to alter its electrical properties.

9. The method of claim 1, wherein:
the semiconductor sample includes a dielectric coating overlaying semiconducting material;
in step (b) the contacts touch a surface of the dielectric coating opposite the semiconducting material; and
in step (c) the current is a tunneling current which flows through the dielectric coating between the semiconducting material and each of the subset contacts.

10. The method of claim 9, wherein the current is constrained whereupon no irreversible changes occur to the dielectric coating.

11. The method of claim 9, wherein the dielectric coating is either an intentionally applied coating or an insulating coating that grows on the semiconductor material in response to exposure to an ambient atmosphere.

12. The method of claim 9, wherein the dielectric coating is a layer of silicon dioxide having a thickness less than or equal to 30 angstroms.

13. The method of claim 1, wherein the contacts are each formed from one of platinum and iridium.

14. The method of claim 1, wherein:
the semiconductor sample is comprised of semiconducting material; and
the semiconducting material includes dopant atoms that have been introduced thereinto via a surface thereof to alter its electrical properties.

15. The method of claim 14, wherein the dopant atoms form a P-N junction below said surface.

16. The method of claim 14, wherein:
the dopant atoms reside in the semiconducting material adjacent said surface; and
the current in step (c) is constrained to the semiconducting material containing said dopant atoms.

17. The method of claim 14, wherein the semiconductor sample includes a dielectric coating overlaying the semiconducting material.

18. The method of claim 17, wherein in step (c) the current flowing between the semiconducting material and each of the subset of contacts is a tunneling current; the current is constrained whereupon no irreversible changes occur to the dielectric coating; and the current is constrained to flow in a layer of the semiconducting material adjacent a surface thereof.

19. The method of claim 1, wherein the current in step (c) either a DC current or a DC current having an AC current superimposed thereon.

20. The method of claim 19, wherein the AC current has a maximum or peak value that does not significantly vary a resistivity of the semiconductor sample.

21. The method of claim 1, wherein the current in step (c) is one of a plurality of DC currents.

22. The method of claim 21, wherein each of the plurality of DC currents has a value whereupon a resistivity determined for the semiconductor sample for each value of DC current is substantially similar.

23. A method of testing a semiconductor layer on a supporting wafer sample comprising:
(a) providing a plurality of spaced probes, wherein each probe is formed of an elastically deformable and electrically conductive material that either does not form an oxide(s) or other insulator on its surface or which forms a conductive oxide(s) or other material thereon;
(b) causing the probes and a surface of the semiconductor layer to touch whereupon tips of the probes deform within their elastic limits but do not penetrate or damage the surface of the semiconductor layer;
(c) causing a current to flow in the semiconductor layer via a first subset of the contacts;
(d) measuring a voltage induced in the semiconductor layer in response to the current flowing therein via a second subset of the contacts; and
(e) determining at least one electrical characteristic of the semiconductor layer as a function of the value of the current flowing therein and the measured voltage.

24. The method of claim 23, wherein:
the first and second subset of contacts can be the same or different; and
each subset of contacts includes all or less than all of the plurality of contacts.

25. The method of claim 23, wherein:
step (a) includes providing two contacts;
step (c) includes causing the current to flow in the semiconductor layer via the two contacts;
step (d) includes measuring the voltage induced in the semiconductor layer via the two contacts; and
step (e) includes determining at least one of a resistivity of the semiconductor layer, a sheet resistance of the semiconductor layer, and a density of dopant atoms that have been introduced into semiconducting material of the semiconductor layer to alter its electrical properties.

26. The method of claim 23, wherein:
step (a) includes providing three contacts;
step (c) includes causing the current to flow in the semiconductor layer via two of the contacts;
step (d) includes measuring the voltage induced in the semiconductor layer via the remaining contact and one of the current-carrying contacts; and
step (e) includes determining at least one of a resistivity of the semiconductor layer, a sheet resistance of the semiconductor layer, and a density of dopant atoms that have been introduced into semiconducting material of the semiconductor layer to alter its electrical properties.

27. The method of claim 23, wherein:
step (a) includes providing four contacts;
step (c) includes causing the current to flow in the semiconductor layer via two of the contacts;
step (d) includes measuring the voltage induced in the semiconductor layer via the two other contacts; and
step (e) includes determining at least one of a resistivity of the semiconductor layer, a sheet resistance of the semiconductor layer, and a density of dopant atoms that have been introduced into semiconducting material of the semiconductor layer to alter its electrical properties.

28. The method of claim 27, wherein the physical spacing and relative locations of the four contacts is selected to define the region of the semiconductor layer where the at least one electrical characteristic of the semiconductor layer is determined.

29. The method of claim 23, wherein the plurality of contacts is spaced linearly.

30. The method of claim 23, further including repeating steps (c) - (d) a plurality of times with a different spacing between the subset of contacts for each repetition of steps (c) - (d), wherein step (e) includes determining as a function of the current flowing in the semiconductor layer and the measured voltage for each repetition of steps (c) - (d) at least one of a resistivity of the semiconductor layer, a sheet resistance of the semiconductor layer, and a density of dopant atoms that have been introduced into semiconducting material of the semiconductor layer to alter its electrical properties.

31. The method of claim 23, wherein:
the semiconductor layer includes a dielectric coating overlaying semiconducting material;
in step (b) the contacts touch a surface of the dielectric coating opposite the semiconducting material; and
in step (c) the current is a tunneling current which flows through the dielectric coating between the semiconducting material and each of the subset contacts.

32. The method of claim 31, wherein the current is constrained whereupon no irreversible changes occur to the dielectric coating.

33. The method of claim 31, wherein the dielectric coating is either an intentionally applied coating or a native oxide coating that grows on the semiconductor material in response to exposure to an ambient atmosphere.

34. The method of claim 31, wherein the dielectric coating is a layer of silicon dioxide having a thickness less than or equal to 30 angstroms.

35. The method of claim 23, wherein the contacts are each formed from one of platinum and iridium.

36. The method of claim 23, wherein:
the semiconductor layer is comprised of semiconducting material; and
the semiconducting material includes dopant atoms that have been introduced thereinto via a surface thereof to alter its electrical properties.

37. The method of claim 36, wherein the dopant atoms form a P-N junction below said surface.

38. The method of claim 36, wherein:
the dopant atoms reside in the semiconducting material adjacent said surface; and
the current in step (c) is constrained to the semiconducting material containing said dopant atoms.

39. The method of claim 36, wherein the semiconductor layer includes a dielectric coating overlaying the semiconducting material.

40. The method of claim 39, wherein in step (c) the current flowing between the semiconducting material and each of the subset of contacts is a tunneling current; the current is constrained whereupon no irreversible changes occur to the dielectric coating; and the current is constrained to flow in a layer of the semiconducting material adjacent a surface thereof.

41. The method of claim 23, wherein the current in step (c) is either a DC current or a DC current having an AC current superimposed thereon.

42. The method of claim 41, wherein the AC current has a maximum or peak value that does not significantly vary a resistivity of the semiconductor layer.

43. The method of claim 23, wherein the current in step (c) is one of a plurality of DC currents.

44. The method of claim 43, wherein each of the plurality of DC currents has a value whereupon a resistivity determined for the semiconductor layer for each value of DC current is substantially similar.

45. A method of testing a conductive film overlaying a semiconductor wafer or sample comprising:
(a) providing a plurality of spaced contacts, wherein each contact is formed from an elastically deformable and electrically conductive material that either does not form an oxide(s) thereon or which forms a conductive oxide(s) thereon;
(b) causing the contacts and a surface of the conductive film to touch whereupon the contacts deform within their elastic limits but do not penetrate or damage the surface of the conductive film;
(c) causing a current to flow in the conductive film via a subset of the contacts;
(d) measuring a voltage induced in the conductive film in response to the current flowing therein; and
(e) determining at least one electrical characteristic of the conductive film as a function of the value of the current flowing therein and the measured voltage.
